# EUROPÄISCHE PATENTSCHRIFT

(11) **EP 0 905 780 B1**
(45) Veröffentlichungstag und Bekanntmachung des Hinweises auf die Patenterteilung: **13.11.2002**
(21) Anmeldenummer: 98114550.1
(22) Anmeldetag: 03.08.1998
(51) Int. Cl.: H01L 27/02

(54) **Integrierte Halbleiterschaltung mit Schutzstruktur zum Schutz vor elektrostatischer Entladung**
Integrated circuit with a protection structure against electrostatic discharge
Circuit intégré avec une structure de protection contre les décharges électrostatiques

(30) Priorität: 30.09.1997 DE 19743240
(43) Veröffentlichungstag der Anmeldung: 31.03.1999
(73) Patentinhaber: Infineon Technologies AG, 81669 München (DE)
(72) Erfinder: Stecher, Matthias, 9500 Villach (AT); Gossner, Harald, 81735 München (DE); Schwetlick, Werner, 82194 Gröbenzell (DE)
(74) Vertreter: Reinhard - Skuhra - Weise & Partner

(56) Entgegenhaltungen:
- EP-A- 0 532 481
- US-A- 5 471 082
- US-A- 5 644 460

## Beschreibung

Die Erfindung betrifft eine integrierte Halbleiterschaltung, gemäß dem Oberbegriff des Anpruch wie aus der EP 0532481A1 bekannt.

Ein Weiteres sogenanntes ESD-Schutzelement ist aus J. Chen, X. Zhang, A. Amerasekera, T. Vrotsos, "Design and Layout of a High ESD Performance NPN Structure for Submicron BiCMOS-/Bipolar Circuits", Proceeding of the IEEE International Reliability Physics Symposium (1996), S. 227 - 232, bekannt.

In einem Chip integrierte Halbleiterschaltungen enthalten Schutzschaltungen zum Schutz der Ein- oder Ausgänge (I/O-Ports) gegen elektrostatische Überspannungen und dadurch verursachte elektrostatische Entladungen (Electrostatic Discharge (ESD)). Diese sogenannten ESD-Schutzelemente sind zwischen dem Eingangspad einer integrierten Halbleiterschaltung und dem zu schützenden Eingangs- oder Ausgangsanschluß angeschlossen und sorgen somit dafür, daß bei Einkopplung einer parasitären Überspannung das ESD-Schutzelement durchschaltet und der parasitäre Überspannungsimpuls somit an eine der Versorgungsspannungsleiterbahnen abgeleitet wird. Derartige Überspannungsimpulse können im Extremfall zur Zerstörung des Bauteiles führen.

Unter Operationsbedingungen, wie sie z. B. in der Produktspezifikation beschrieben sind, dürfen die ESD-Schutzelemente die Funktion der zu schützenden integrierten Halbleiterschaltungen jedoch nicht beeinträchtigen. Das bedeutet, daß die Durchschaltspannung der ESD-Schutzelemente außerhalb des Signalspannungsbereiches der geschützten Anschlußpads liegen muß. Um eine gute Schutzwirkung entfalten zu können, sollte das ESD-Schutzelement vor dem kritischsten Schaltungspfad durchbrechen. Dies erfordert in der Regel eine exakte Einstellung der Durchschaltspannung der jeweiligen ESD-Schutzelemente mit der wesentlichen Randbedingung, daß die Prozeßführung, die hinsichtlich der Eigenschaften der Bauelemente der zu schützenden integrierten Halbleiterschaltung optimiert wurde, durch das Einfügen der ESD-Schutzelemente nicht verändert wird.

Eine weitere wesentliche Randbedingung ergibt sich aus der räumlichen Anordnung der Anschlußpads in unmittelbarer Nähe der zu schützenden integrierten Halbleiterschaltung. Insbesondere werden die Anschlußpads wegen des relativ hohen zu treibenden Strom in der Nähe der Ausgangstreiber angeordnet. Die ESD-Schutzstruktur wird daher häufig an diejenige Versorgungsleitung angeschlossen, aus der der Ausgangstreiber versorgt wird.

Bei Schutzelementen, die ein ausgeprägtes Snap-Back-Verhalten aufweisen, wie zum Beipiel Thyristoren und Bipolartransistoren, kann es bei sehr schnellen Einschaltvorgängen oder Störimpulsen zu einem Durchschalten kommen, obwohl die durch Kennlinienmessung im Niederstrombereich bestimmte Durchbruchspannung außerhalb des spezifizierten Signalspannungsbereichs liegt. Dies wird auch als sogenannter transienter Latch-Up-Effekt bezeichnet und führt in der Regel zur Zerstörung des ESD-Schutzelementes. Der transiente Latch-Up tritt insbesondere bei Smart-Power-Anwendungen auf.

Aus diesem Grund können trotz hoher ESD-Festigkeit und guter Schutzwirkung wegen des transienten Latch-Up derartige Thyristoren oder Bipolartransistoren nicht als ESD-Schutzelemente eingesetzt werden. Hier ist man auf Durchbruchdioden oder Transistoren mit einer geringen Verstärkung beschränkt. Diese Bauelemente weisen jedoch eine sehr viel geringere ESD-Festigkeit auf.

Bezüglich weiterer Einzelheiten, Merkmale, deren Vorteile und Wirkungsweise der ESD-Schutzschaltungen wird ausdrücklich auf die Europäische Patentanmeldung EP 0 623 958 A1 sowie auf das eingangs genannte Dokument von J. Chen et al. verwiesen und vollinhaltlich Bezug genommen ("incorporated by reference").

Ausgehend von diesem Stand der Technik liegt der Erfindung daher die Aufgabe zugrunde, ein ESD-Schutzelement der eingangs genannten Art bereitzustellen, bei der der Triggerstrom einstellbar ist und das die oben genannten Nachteile nicht aufweist.

Erfindungsgemäß wird diese Aufgabe gelöst durch eine integrierte Halbleiterschaltung gemäß Anspruch 1.

Erfindungsgemäß werden dabei vertikale npn-Bipolartransistoren als ESD-Schutzelemente genutzt, deren Basis durch eine Diode im Durchbruch angesteuert wird, wobei deren Durchbruchspannung über der Haltespannung der npn-Bipolartransistoren liegt. Durch geeignete Wahl der Lage des Basiskontaktes, kann die Stromführung und damit der Spannungsabfall in der Basis des npn-Transistors beeinflußt werden. Dadurch wird eine gezielte Einstellung des Triggerstromes möglich. Es wäre auch möglich, den Basiskontakt bzw. den Schottkykontakt auf dem Basisgebiet wegzulassen. Somit kann sowohl die Signalspannnungsanforderung erfüllt werden, als auch eine Optimierung der ESD-Festigkeit erreicht werden.

Besonders vorteilhaft ist die Erfindung, wenn der Schutztransistor durch eine in Sperrichtung geschaltete Diode angesteuert wird. Insbesondere bei Beschaltung der Basis mit einer Diode, deren Durchbruch im Bereich der Haltespannung des Schutztransistors liegt. Dadurch läßt sich ein fast ideales ESD-Schutzelement entwickeln, das eine einstellbare Spannungsbegrenzung bis in den Amperebereich zwischen der Signalspannungsobergrenze und der Haltespannung besitzt. Die Durchschaltspannung des Schutzelementes läßt sich dabei durch die anodenseitige Dotierungskonzentration sowie durch die anodenseitige Dicke der Driftzone der Diode einstellen.

Besonders vorteilhaft ist es, wenn zwischen Emitter- und Basisanschlüssen des Schutztransistors ein integrierter Widerstand vorgesehen ist. Der integrierte Widerstand läßt sich die Ansteuerempfindlichkeit der Basis des Schutztransistors einstellen. Typischerweise ist der integrierte Widerstand bei geeigneter Verschaltung der Emitter- und Basisanschlüsse durch den Leitwert der Basiszone festgelegt.

Die vergrabene Schicht ist dabei über eine Anschlußzone, die aus Gründen einer guten Leitfähigkeit möglichst hoch dotiert ist, mit dem Anschlußpad verbunden. Die Anschlußzone definiert dabei einen Teilbereich, in dem die Schutzelemente angeordnet sind. Typischerweise ist der Teilbereich in einer Epitaxieschicht angeordnet. Besonders vorteilhaft ist es, wenn die Anschlußzone ringförmig als geschlossener Ring um den Teilbereich angeordnet ist.

Die Anschlußzonen sind dabei äquidistant durch einen zweiten Abstand von den Basiszonen und/oder von den zweiten Emitterzonen beabstandet. Der zweite Abstand ist typischerweise ausreichend groß zu wählen, so daß der parasitäre Bipolartransistor im Randbereich der Teilzone nicht durchschaltet.

Typischerweise ist die laterale Querschnittsfläche der vergrabenen Schicht größer als die laterale Querschnittsfläche der Anschlußzone und des Teilbereichs. Der Teilbereich ist dabei typischerweise in einer Epitaxieschicht des Halbleiterkörpers angeordnet.

Typischerweise weisen die Emitterzonen eine sehr viel höhere Dotierungskonzentration auf, als die Basiszonen bzw. die Epitaxieschicht. Die Dotierungskonzentration in der Epitaxieschicht ist oftmals von der Prozeßführung zur Herstellung der integrierten Schaltung festgelegt.

Die vergrabene Schicht und die Anschlußzonen sind um den Anforderungen eines sehr hohen Leitwertes Genüge zu leisten, sehr hoch dotiert. Typischerweise weisen diese Zonen eine Dotierungskonzentration von mehr als 1*10¹⁹ cm⁻³ auf.

Es ist auch denkbar, eine Anodenzone zwischen Kollektoranschluß und Anschlußpad anzuordnen ist. In diesem Fall ist das ESD-Schutzelement als IGBT oder als Thyristor ausgebildet.

Besonders vorteilhaft ist die Erfindung bei Verwendung in einem Halbleiterspeicher oder einem Logikbauteil. Eine weitere vorteilhafte Anwendung findet die Erfindung in der Verwendung in einem Mikrokontroller.

Typischerweise ist die Erfindung in bipolar realisierten Schaltungen integriert. Dabei kann der Schalttransistor ein npn-Bipolartransistor sein und der Ansteuertransistor ein pnp-Bipolartransistor. Besonders vorteilhaft ist es jedoch, wenn die integrierte Halbleiterschaltung sowie das ESD-Schutzelement in CMOS-Technologie hergestellt ist. In diesem Fall ist der Schalttransistor beispielsweise ein n-Kanal MOSFET und der Ansteuertransistor ein p-Kanal MOSFET.

Vorteilhafte Ausgestaltungen und Weiterbildungen sind Gegenstand der Unteransprüche.

Nachfolgend wird die Erfindung anhand den in den Figuren der Zeichnung angegebenen Ausführungsbeispiele näher erläutert. Es zeigt dabei:
- Figur 1: die Schaltungsanordnung einer bekannten integrierten Halbleiterschaltung mit vorgeschaltetem ESD-Schutzelement;
- Figur 2: eine schematische Darstellung der Realisierung einer erfindungsgemäßen ESD-Schutzstruktur in einem Halbleitersystem mit geringem Triggerstrom;
- Figur 3: eine schematische Darstellung der Realisierung einer nicht zur Erfindung gehörenden ESD-Schutzstruktur in einem Halbleitersystem mit hohem Triggerstrom;
- Figur 4: die Hochstromkennlinie einer realen Diode (a) sowie eines ESD-Schutzelementes mit geringem Triggerstrom (b) und mit hohem Triggerstrom (c).

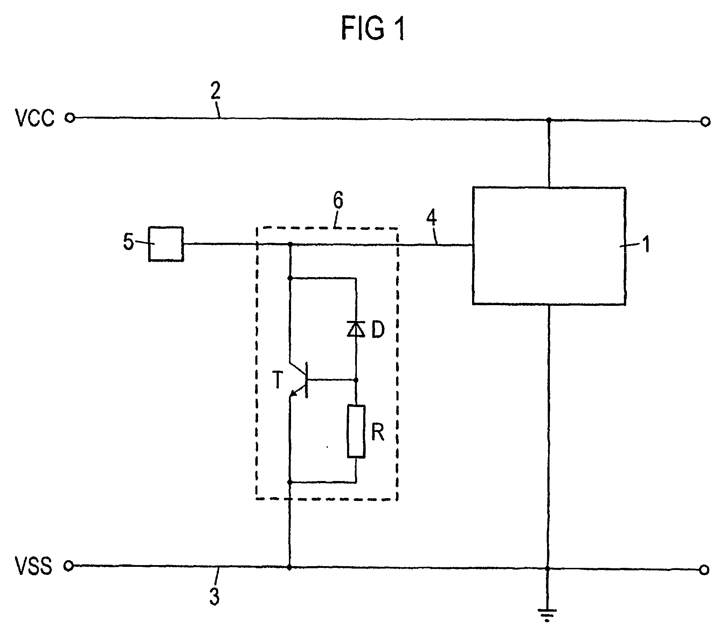

Figur 1 zeigt eine Schaltungsanordnung einer bekannten integrierten Halbleiterschaltung mit vorgeschaltetem ESD-Schutzelement.

In Figur 1 ist mit 1 die integrierte Halbleiterschaltung bezeichnet. Die integrierte Halbleiterschaltung 1 ist an eine erste Potentialschiene 2 mit einem ersten Versorgungspotential VCC sowie eine zweite Potentialschiene 3 mit einem zweiten Versorgungspotential VSS angeschlossen. Das erste Versorgungspotential VCC kann beispielsweise die Versorgungsspannung sein. Das zweite Versorgungspotential VSS kann wie im vorliegenden Beispiel die Bezugsmasse sein.

Über eine Verbindungsleitung 4 ist die integrierte Halbleiterschaltung 1 mit einem Anschlußpad 5 verbunden. Das Anschlußpad 5 kann sowohl ein Eingangsanschluß zur Einkopplung von Eingangssignalen in die integrierte Halbleiterschaltung 1 sein, als auch ein Ausgangsanschluß zum Auskoppeln von Ausgangssignalen aus der integrierten Halbleiterschaltung 1. Derartige Anschlüsse werden auch als I/O-Ports bezeichnet.

Zwischen das Anschlußpad 5 und der integrierten Halbleiterschaltung 1 ist ein ESD-Schutzelement 6 geschaltet. Außerdem ist das ESD-Schutzelement 6 mit der zweiten Potentialschiene 3 verbunden.

Im vorliegenden Beispiel besteht das ESD-Schutzelement 6 aus einem npn-Schutztransistor T, dessen Laststrecke zwischen der Verbindungsleitung 4 und der Potentialschiene 3 geschaltet ist. Es wäre auch denkbar, als Schutztransistor T einen pnp-Transistor zu verwenden. Dies hängt jedoch von der zugrunde liegenden Technologie zur Herstellung der integrierten Halbleiterschaltung 1 ab. Es wäre natürlich auch denkbar, den Schutztransistor T alternativ als MOSFET, als Sperrschicht-FET, als Thyristor, als IGBT oder als ein gängiges steuerbares Bauelement, das geeignet verschaltet ist, zu realisieren.

Zwischen der Basis-Kollektor-Strecke des Schutztransistors T ist eine Diode D vorgesehen. Zwischen der Basis-Emitter-Strecke des Schutztransistors T ist ein Widerstand R vorgesehen. Im vorliegenden Beispiel wird der Basisanschluß des Schutztransistors T durch die in Sperrichtung geschaltete Diode D aktiv angesteuert. Die Ansteuerspannung des Schutztransistors T kann über eine geeignete Dimensionierung des Widerstandes R eingestellt werden. Es ist jedoch auch denkbar, daß der Schutztransistor T nicht aktiv angesteuert wird. In diesem Fall kann auf die Diode D verzichtet werden.

Im vorliegenden Beispiel ist das ESD-Schutzelement 6 zwischen der Anschlußleitung 4 und der zweiten Potentialschiene 3 geschaltet. Es wäre selbstverständlich auch denkbar, das ESD-Schutzelement 6 zwischen der Verbindungsleitung 4 und der ersten Potentialschiene 2 bzw. zwischen der Verbindungsleitung 4 und beiden Potentialschienen 2, 3 anzuordnen.

Das ESD-Schutzelement 6 soll die integrierte Halbleiterschaltung 1 vor parasitären, über das Anschlußpad 5 eingekoppelten Störsignalen schützen. Diese parasitären Störsignale werden über das ESD-Schutzelement 6 an eine der Potentialschienen 2, 3 abgeleitet und gelangen somit nicht in die integrierte Halbleiterschaltung 1.

Derartige Störsignale können beispielsweise beim Transport bzw. beim Handling des Halbleiterchips entstehen. Dadurch kann der Halbleiterchip elektrostatisch aufgeladen werden. Wird die elektrostatische Ladung in die integrierte Halbleiterschaltung 1 eingekoppelt, kann dies im Extremfall zur Zerstörung der integrierten Halbleiterschaltung 1 führen.

Zur Simulierung einer Störsignaleinkopplung wird typischerweise das sogenannte Human-Body-Modell (HBM) angewendet. Das Ersatzschaltbild des Human-Body-Modells sieht einen Tiefpaß, bestehend aus einer Kapazität von 100 pF und einem Widerstand von 1,5 KΩ, vor. Das Human-Body-Modell simuliert ein durch einen Menschen eingekoppeltes Störsignal. Es ist auch denkbar, andere Modelle wie beispielsweise das sogenannte Charged-Device-Modell (CDM) zu verwenden.

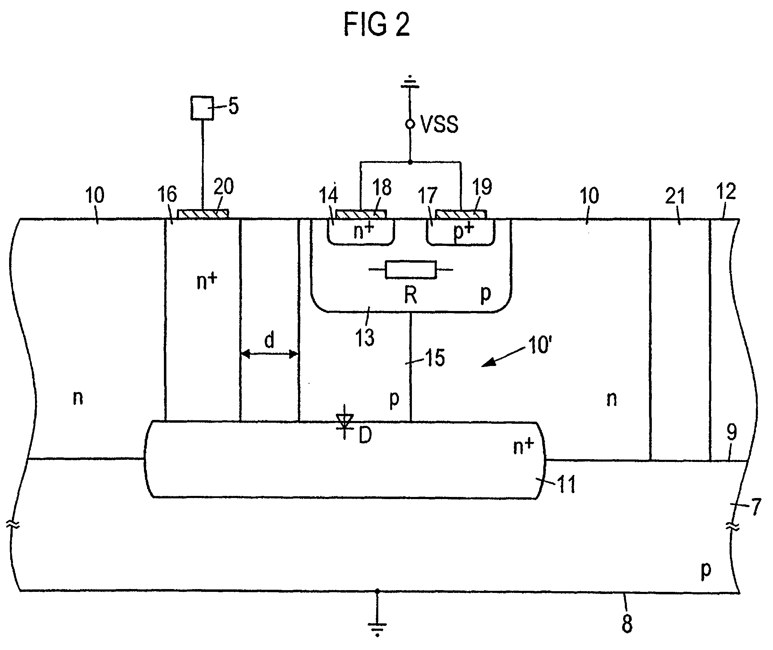

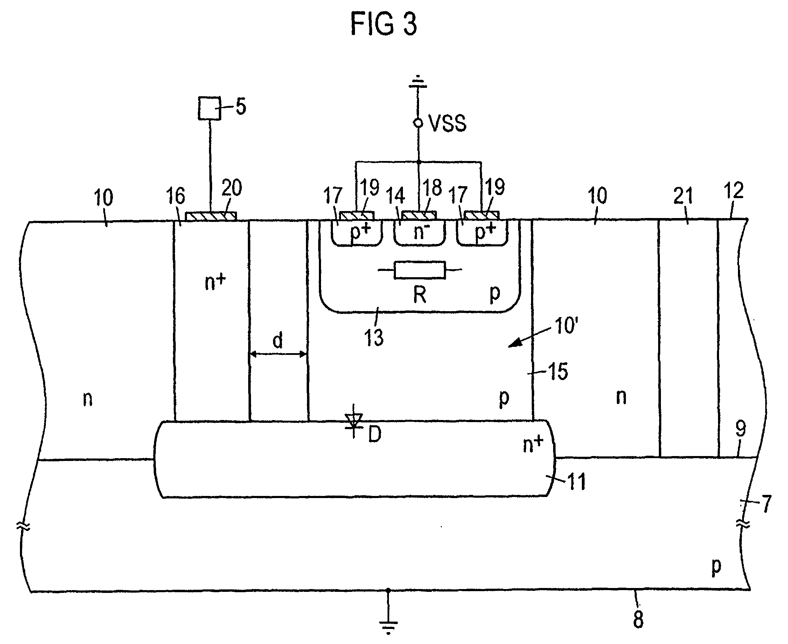

Figur 2 und 3 zeigen jeweils eine schematische Darstellung der Realisierung eines ESD-Schutzelements mit geringem bzw. mit hohen Triggerstrom. Gleiche Elemente sind entsprechend Figur 1 mit gleichen Bezugszeichen versehen.

In Figur 2 und 3 ist mit 7 ein Halbleiterkörper bezeichnet. Der Halbleiterkörper 7 besteht typischerweise aus Siliziumsubstrat. Der Halbleiterkörper 7 weist eine Scheibenrückseite 8 und eine Substratoberfläche 9 auf. Die Scheibenrückseite 8 kann beispielsweise über eine gängige großflächige Metallisierung auf dem Bezugspotential liegen. Im vorliegenden Beispiel ist das Siliziumsubstrat des Halbleiterkörpers 7 p-dotiert und liegt auf der Scheibenrückseite 8 auf dem Potential der Bezugsmasse. Es ist selbstverständlich auch denkbar, daß das Halbleitersubstrat n-dotiert ist.

Auf der Substratoberfläche 9 des Halbleiterkörpers 7 ist eine schwach n-dotierte Epitaxieschicht 10 aufgebracht. Für die Funktion der ESD-Schutzstruktur wäre es auch denkbar mehrere Epitaxieschichten 10 übereinander anzuordnen oder auf die Epitaxieschicht 10 ganz zu verzichten. Die Dotierungskonzentration in der Epitaxieschicht 10 ist von der Prozeßführung zur Herstellung der integrierten Halbleiterschaltung 1 festgelegt. Typischerweise weist die Epitaxieschicht eine Dotierungskonzentration von 1*10¹⁵ cm⁻³ bis 1*10¹⁸ cm⁻³ auf. Die Dicke der Epitaxieschicht hängt von den durch die Technologie vorgegebenen Strukturen der zu schützenden Integrierten Schaltung 1 ab.

Zusätzlich ist, wie in Figur 2 gezeigt, eine vergrabene Schicht 11 vorgesehen. Eine derartige vergrabene Schicht 11 wird auch als Burried-Layer bezeichnet. Im vorliegenden Beispiel ist die vergrabene Schicht 11 n+-dotiert. Die vergrabene Schicht 11 kann beispielsweise durch Einbringen eines Depots auf der Substratoberfläche 9 vor Aufwachsen der Epitaxieschicht 10 und anschließender Diffusion bei geeigneter Temperatur erzeugt werden.

Es ist jedoch auch vorteilhaft, wenn die vergrabene Schicht 11 durch Ionenimplantation in den Halbleiterkörper 7 nach Aufwachsen bzw. während dem Aufwachsen der Epitaxieschicht 10 erzeugt wird. Um das gewünschte vertikale Profil zu erzielen, ist hierbei häufig eine Mehrfachimplantation bei geeigneten Energien und Dotierungsdosen erforderlich. Hieran sollte ein Temperaturschritt zur homogenen Verteilung der Dotieratome in dem Diffusionsgebiet 9 angeschlossen werden.

Die Dotierungskonzentration in der vergrabenen Schicht 11 ist oftmals durch die Prozeßführung bei der Herstellung der integrierten Schaltung 1 vorgegeben. Die vergrabene Schicht 11 ist dabei möglichst niederohmig ausgebildet und weist eine typische Dotierungskonzentration von etwa 10¹⁹ cm⁻³ auf. Der Abstand der vergrabenen Schicht 11 von der Scheibenoberfläche 12 varriert je nach der zugrunde liegender Technologie zwischen 1-10 µm.

Die vergrabene Schicht 11 ist über eine Anschlußzone 16 mit der Scheibenvorderseite 12 des Halbleiterkörpers 1 verbunden. Die Anschlußzone 16 ist vom selben Leitungstyp wie die vergrabene Schicht 11 und weist typischerweise eine sehr hohe Dotierungskonzentration von größer 1*10¹⁹ cm⁻³ auf. Die Anschlußzone 16 erstreckt sich im vorliegenden Beispiel von der Scheibenoberfläche 12 in den Halbleiterkörper 7 hinein und ist an die vergrabene Schicht 11 angeschlossen. Die Anschlußzone 16 ist hier als tiefe Implantationsschicht ausgebildet. Es wäre jedoch auch denkbar die Anschlußzone als Graben (engl.: Trench) auszubilden, der sich in bekannter Trench-Technologie erzeugen läßt.

Die vergrabene Schicht 11 einerseits und andererseits die Anschlußzonen 16 umfassen einen sogenannten Teilbereich 10' der Epitaxieschicht 10.

Im Teilbereich 10' ist an der Scheibenoberfläche 12 eine Basiszone 13 angeordnet. Die Basiszone 13 ist im vorliegenden Ausführungsbeispiel p-dotiert und wannenförmig ausgebildet. Zusätzlich ist innerhalb der Basiszone 13 an der Scheibenoberfläche 12 eine wannenförmige Emitterzone 14 vom entgegengesetzten Leitungstyp angeordnet. Die Emitterzone 14 weist typischerweise eine Dotierungskonzentration von 5*10¹⁹ cm⁻³ auf, während die Basiszone 13 eine typische Dotierungskonzentration von 10¹⁶ - 10¹⁷cm⁻³ aufweist.

Desweiteren können, wie in den Figuren 2 und 3 gezeigt, p+dotierte Basiskontaktzonen 17 in den Basiszonen 13 vorgesehen sein. Die Basiskontaktzonen sind vom selben Leitungstyp wie die Basiszonen, weisen jedoch eine sehr viel höhere Dotierungskonzentration von typischerweise 5*10¹⁹ cm⁻³ auf. Die Basiskontaktzonen 17 stellen einen definierten elektrischen Kontakt zwischen externen Anschlüssen zur Basiszone 13 her.

Die Basiszone 13, Emitterzone 14 und die Anschlußzone 16 sind über übliche Kontaktierungen 18, 19, 20 an der Scheibenoberfläche 12 kontaktiert. Dabei sind jeweils die Kontaktelektroden 18 der Emitterzonen 14 und die Kontaktelektroden 19 der Basiszone 13 kurzgeschlossen und mit der zweiten Potentialschiene 3 und damit mit der Bezugsmasse verbunden. Die Kontaktelektroden 20 der Anschlußzonen 16 sind mit dem Anschlußpad 5 verbunden.

Zwischen der Basiszone 13 und der vergrabenen Schicht ist ein p-dotiertes Basisdriftgebiet 15 vorgesehen. Das Basisdriftgebiet 15 ist dabei vom selben Leitungstyp wie die Basiszone 13 und ist beispielsweise durch Ionenimplantation herstellbar. Die Dotierungskonzentration des Basisdriftgebietes 15 ergibt sich aus der gewünschten Durchschaltspannung der ESD-Schutzstruktur.

Für die in den Figuren 2 und 3 gezeigten Strukturen gilt das in Figur 1 gezeigte Ersatzschaltbild eines ESD-Schutzelements 6 mit einem Schutztransistor T sowie einer Diode D und einem Widerstand R zur Basisansteuerung des Schutztransistors T. Dabei bilden die Emitterzone 14, die Basiszone 13 und die vergrabene Schicht 11 jeweils den Emitter, die Basis und den Kollektor des Schutztransistors T. Der Übersichtlichkeit halber ist das Ersatzschaltbild aus Figur 1 in den Figuren 2 und 3 nicht eingezeichnet worden. Lediglich die Lage des integrierten Widerstandes R und der integrierten Diode D wurde in den Figuren 2 und 3 angedeutet.

Der integrierter Widerstand R resultiert bei der gegebenen Verschaltung aus der Dotierungskonzentration in der Basiszone 13 zwischen benachbarten Kontaktgebieten der Emitterzone 14 und der Basiskontaktzone 17. Des weiteren ist in den Figuren 2 und 3 jeweils zwischen dem Basisdriftgebiet 15 und der vergrabenen Schicht 11 eine integrierte Diode D angedeutet. Die Dioden D und der Widerstand R steuern dabei die Basis des Schutztransistors T an. Der Leitwert des Widerstandes R bestimmt dabei die Ansteuerempfindlichkeit. Der Transistor T ist dabei um so leicher durchschaltbar, je größer der Leitwert des Widerstandes R gewählt wird. Durch die Dotierungskonzentration im Basisdriftgebiet 15 und durch den Abstand der Basiszone 13 zur vergrabenen Schicht 11 wird die Durchbruchspannung der Diode D und damit des Schutztransistors T bestimmt.

Nachfolgend wird die Funktionsweise der erfindungsgemäßen ESD-Schutzstruktur entsprechend der Figur 2 näher erläutert.

Wird über das Anschlußpad 5 ein Störsignal eingekoppelt und überschreitet dieses Störsignal die Schaltschwelle des Schutztransistors T, dann wird die Diode D zwischen vergrabener Schicht 11 und Basisdriftgebiet 15 im Durchbruch betrieben. Durch den Durchbruchstrom wird gleichzeitig die Basis des Schutztransistors T derart angesteuert, daß bei ausreichend hohem Basisstrom der Schutztransistor T leitend gesteuert wird. Somit ergibt sich ein Strompfad vom Anschlußpad 5 über die Anschlußzonen 16, die vergrabene Schicht 11, der Basisdriftzone 15, der Basiszone 13 zur Emitterzone 14 und somit zur zweiten Potentialschiene 3. Das Störsignal wird somit auf die zweite Potentialschiene 3 abgeleitet und gelangt damit nicht in die integrierte Halbleiterschaltung 1.

Die in den Figuren 2 und 3 gezeigten Beispiele unterscheiden sich voneinander durch die Platzierung der Basisdriftzone 15 im Teilbereich 10'. Durch geeignete Anordnung der Basisdriftzone 15 gegenüber der Basiszone 13 sowie den hochdotierten Kontaktgebiete der Emitterzone und der Basiskontaktzone 17 ist der Triggerstrom von angesteuerten npn-Bipolartransistoren gezielt einstellbar. Durch das gezielte Einstellen des Triggerstroms läßt sich das gewünschte du/dt-Einschaltverhalten erzielen.

In Figur 2 ist dabei das Basisdriftgebiet 15 im wesentlichen vertikal unterhalb des Emitterkontaktes 14 des Schutztransistors T angeordnet. Der Basiskontakt 17 des Schutztransistors und damit auch die Anode der Diode D ist hier in einem Bereich der Basiszone 13 angeordnet, der zwar ebenfalls oberhalb des Basisdriftgebiet 15 angeordnet ist, jedoch zusätzlich horizontal verschoben angeordnet ist.

Die Grundidee dabei ist wie folgt: Muß aufgrund der Plazierung des Basiskontaktes 17 bzw. der Anode der Diode D ein großer Teil des Diodenstroms im Durchbruch durch die Basiszone 13 des npn-Bipolartransistors fließen, so tritt dort ein relevanter Spannungsabfall auf. In diesem Fall erfolgt der Snap-Back bereits bei niedrigen Triggerströmen. Wird der Basiskontakt 17 so plaziert, daß der überwiegende Teil des Diodenstromes im wesentlichen vertikal abfließt und es damit nur zu einem geringen Spannungsabfall in der Basis kommt, werden hohe Triggerströme erreicht.

In Figur 3 hingegen umhüllt das Basisdriftgebiet 15 die gesamte Basiszone 13. Hier weist die Stromführung im wesentlichen eine vertikale Komponente auf, währende die horizontale Komponente hier vernachlässigt werden kann. Somit ist hier der Spannungsabfall in der Basiszone 13 minimal, was zu hohen Triggerströmen führt.

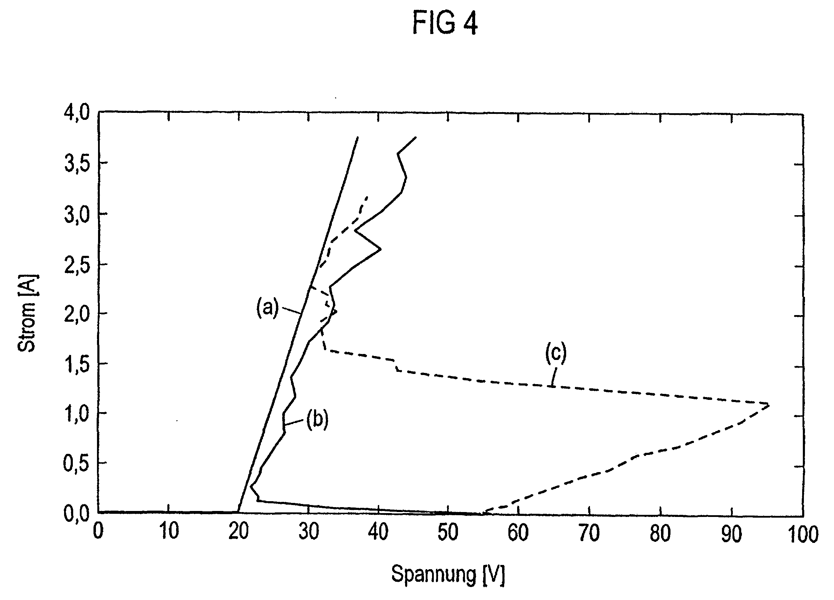

Figur 4 zeigt die Hochstromkennlinie eines ESD-Schutzelementes mit geringem Triggerstrom (b) und mit hohem Triggerstrom (c).

Idealerweise sollte das ESD-Schutzelement das Schaltverhalten einer realen Diode ensprechend der Kennlinie (a) aufweisen. Dieses Verhalten ist jedoch in der Praxis bei gattungsgemäßen ESD-Schutzelementen nicht realisierbar. In der Realität weisen diese Schutzelemente eine Kennlinie entsprechend (b) und (c) auf.

In Kennlinie (b) ist die Hochstromkennlinie einer ESD-Struktur mit niedrigen Triggerströmen entsprechend Figur 2 gezeigt. Dieses Schutzelement weist eine Spannungsbegrenzung bei niedrigen Werten und damit eine gute Schutzwirkung auf. Allerdings kann es bei schnellen Spannungsimpulsen im Normalbetrieb dazu kommen, daß dieses Schutzelement ungewollt durchschaltet. Dies ist insbesondere dann der Fall, wenn beispielsweise ein für die integrierte Schaltung 1 bestimmtes Signal einen leichten Jitter bei schnellen Einschaltflanken oder einen leicht erhöhten Spannungsimpuls, der über der Durchschaltschwelle liegt, aufweist. In diesem Fall wird dieses Signal unbeabsichtigterweise über das ESD-Schutzelement abgeleitet.

In Kennlinie (c) ist die Hochstromkennlinie einer ESD-Struktur mit hohen Triggerströmen entsprechend Figur 3 gezeigt. Diese Kennlinien weist ein markantes Snap-Back-Verhalten auf. Dieses Schutzelement begrenzt die Spannung bei höheren Werten und zeigt damit eine schlechtere Schutzwirkung. Allerdings ist die Gefahr eines unbeabsichtigten Durchschaltens geringer.

Vorteilhafterweise ist je nach Technologievorgabe und Anforderungen an der integrierten Schaltung somit ein erfindungsgemäßes ESD-Schutzelement zu realisieren, dessen Kennlinie etwa zwischen den Kennlinien (b) und (c) liegt. Eine derartige Kennlinie vereinigt dann die Vorteile der ESDschutzelemente mit niedrigem und mit hohem Triggerstrom miteinander.

In der projizierten Draufsicht (nicht dargestellt) beschreiben die vergrabene Schicht 11 sowie der Teilbereich 10' eine ringförmige Struktur. Die ringförmige Struktur muß jedoch nicht notwendigerweise geschlossen sein. Die ringförmige Struktur kann dabei kreisförmig, reckeckig oder vieleckig ausgebildet sein. Alternativ wäre auch eine streifenförmige Struktur denkbar. Typischerweise ist dabei die laterale Querschnittsfläche der vergrabenen Schicht 11 mindestens größer als die laterale Querschnittsfläche des Teilbereichs 10'.

Die Basiszone 13 und die Basisdriftzone 15 sind in dem Teilbereich 10' derart angeordnet, daß sie von der Anschlußzone 16 durch einen Abstand d beabstandet ist. Der Abstand d ist dabei so groß zu wählen, daß die laterale, parasitäre pn-Diode im Randbereich des Teilbereichs 10', der an die Anschlußzone 16 angrenzt, unterdrückt wird. In der Smart Power Technologie (SPT) ist dieser Abstand typischerweise größer als 20µm.

Die Basiszone 13, die Emitterzone 14 und der Basiskontaktzonen 17 sind im vorliegenden Beispiel wannenförmig ausgebildet. Es wären jedoch auch V-förmige, U-förmige, trenchförmige, oder ähnliche Strukturen denkbar. Diese Zonen 13, 14, 17 werden vorteilhafterweise durch Diffusion oder Ionenimplantation in den Halbleiterkörper 7 eingebracht. Es wäre jedoch auch eine alternative Herstellungsmöglichkeit, wie zum Beipiel eine Abscheidung oder ähnliches, denkbar.

Zusätzlich kann wie in Figur 2 und 3 angedeutet, eine Pufferzone 21 vorgesehen sein. Die Pufferzone 21 erstreckt sich hier von der Scheibenvorderseite 12 durch die gesamte Epitaxieschicht 10 bis zur Substratoberfläche 9 und ist an den Halbleiterkörper 7 angeschlossen. Die Pufferzone 21 hat üblicherweise die Funktion der Schirmung bzw. der Trennung des ESD-Schutzelements 6 gegenüber der integrierten Halbleiterschaltung 1 bzw. dem Halbleiterchip.

Die Pufferzone 21 kann durch jedes gängige Puffermaterial, beispielsweise Siliciumdioxid, Siliciumnitrit oder ähnlichem, gebildet werden. Besonders vorteilhaft ist es jedoch, wenn die Pufferzone 21 aus p+-dotiertem Silicium besteht. In diesem Fall kann die in Flußrichtung gepolte pn-Diode zwischen vergrabener Schicht 11 und p-dotiertem Substrat 7 genutzt werden, um beispielsweise negative Pulse abzuführen. Diese negativen Pulse können dann über die p+-dotierte Pufferzone 21 abgeleitet werden.

Es wäre auch vorteilhaft, wenn zwischen vergrabener Schicht 11 und Anschlußpad 5 eine zusätzliche Anodenzone vom entgegengesetzten Leitungstyp wie in der Anschlußzone 16 angeordnet sein. In diesem Fall kann das ESD-Schutzelement 6 auch als IGBT oder als Thyristor ausgebildet sein.

Besonders vorteilhaft ist die Erfindung bei Verwendung des ESD-Schutzelements in einem Mikrokontroller, in einem Halbleiterspeicher oder in einem Logikbauteil.

Die integrierte Halbleiterschaltung sowie das dazugehörige ESD-Schutzelement sind dabei vorzugsweise bipolar realisiert bzw. in Smart-Power-Technologie hergestellt. Besonders vorteilhaft ist es jedoch auch, wenn die integrierte Halbleiterschaltung 1 sowie die ESD-Schutzschaltung in CMOS-Technologie hergestellt ist.

## Patentansprüche

1. Integrierte Halbleiterschaltung (1), die in einem Halbleiterkörper (7) angeordnet ist,
a) mit mindestens einem Anschlußpad (5), das über eine elektrisch leitende Verbindungsleitung (4) mit der integrierten Halbleiterschaltung (1) verbunden ist,
b) mit mindestens einer ersten Potentialschiene (2), die im Betrieb ein erstes Versorgungspotential (VCC) der integrierten Halbleiterschaltung (1) führt,
c) mit mindestens einer zweiten Potentialschiene (3), die im Betrieb ein zweites Versorgungspotential (VSS) der integrierten Halbleiterschaltung (1) führt,
d) mit mindestens einem Schutzelement (6) zum Schutz der integrierten Halbleiterschaltung (1) vor elektrostatischer Entladung, wobei das Schutzelement (6) zwischen das Anschlußpad (5) und der integrierten Halbleiterschaltung (1) angeordnet ist und an mindestens eine der Potentialschienen (2, 3) angeschlossen ist,
e) wobei das Schutzelement (6) mindestens einen integrierten vertikalen Schutztransistor (T) aufweist, dessen Laststrecke zwischen der Verbindungsleitung (4) und einer der Potentialschienen (2, 3) geschaltet ist und dessen Basis über über integrierte Ansteuermittel ansteuerbar ist,
f) wobei das Schutzelement (6) Mittel zur Stromführung aufweist, wobei durch die Mittel zur Stromführung ein parasitärer Stromimpuls in einen horizontalen Anteil und einen vertikalen Anteil aufgeteilt wird,
g) wobei der Kollektor des Schutztransistors (T) in dem Halbleiterkörper (7) durch mindestens eine vergrabene Schicht (11) vom ersten Leitungstyp gebildet wird,
h) wobei mindestens eine in einem Teilbereich (10') einer epitaktischen Schicht (10) vom ersten Leitungstyp eingebrachte Basiszone (13) vom zweiten Leitungstyp, die von der vergrabenen Schicht (11) beabstandet ist, als Basis wirkt,
i) wobei mindestens eine in die Basiszone (13) eingebrachte Emitterzone (14) vom ersten Leitungstyp als Emitter wirkt,
j) wobei mindestens eine in der Basiszone (13) eingebrachte Basiskontaktzone (17) vom ersten Leitungstyp vorgesehen ist, die eine höhere Dotierungskonzentration aufweist als die Basiszone (13)
**dadurch gekennzeichnet, daß**
mindestens eine zwischen der Basiszone (13) und der vergrabenen Schicht (11) angeordnete Basisdriftzone (15) vom ersten Leitungstyp vorgesehen ist, und
die Mittel zur Stromführung aus der horizontalen Verschiebung der Basisdriftzone (15) gegenüber der Basiskontaktzone (17) bestehen.

2. Integrierte Halbleiterschaltung Anspruch 1,
**dadurch gekennzeichnet, daß** die Ansteuermittel mindestens eine zwischen vergrabener Schicht (11) und Basisdriftzone (15) angeordnete, in Sperrichtung geschaltete integrierte Diode (D) enthalten.

3. Integrierte Halbleiterschaltung nach einem der vorhergehenden Ansprüche,
**dadurch gekennzeichnet, daß** die Ansteuermittel mindestens einen integrierten Widerstand (R) enthalten.

4. Integrierte Halbleiterschaltung nach Anspruch 3,
**dadurch gekennzeichnet, daß** der Leitwert des integrierten Widerstandes (R) von der Dotierungskonzentration in der Basiszone (13) festgelegt ist.

5. Integrierte Halbleiterschaltung nach einem der Ansprüche 1 bis 4,
**dadurch gekennzeichnet, daß** die Durchschaltspannung des Schutzelements (6) durch die Dotierungskonzentration der Basisdriftzone (15) und durch die Dikke der Basisdriftzone (15) festgelegt ist.

6. Integrierte Halbleiterschaltung nach einem der Ansprüche 1 bis 5,
**dadurch gekennzeichnet, daß** mindestens eine Anschlußzone (16) vorgesehen ist, die an die vergrabene Schicht (11) angeschlossen ist und die mit einer der Potentialschienen (2, 3) verbunden ist.

7. Integrierte Halbleiterschaltung nach Anspruch 6,
**dadurch gekennzeichnet, daß** die Anschlußzone (16) ringförmig um die Basiszone (13) bzw. die Basisdriftzone (15) angeordnet ist.

8. Integrierte Halbleiterschaltung nach einem der Ansprüche 6 oder 7,
**dadurch gekennzeichnet, daß** die Anschlußzone (16) äquidistant durch einen Abstand (d) von der Basiszone (13) und/oder der Basisdriftzone (15) beabstandet ist.

9. Integrierte Halbleiterschaltung nach einem der Ansprüche 6 bis 8,
**dadurch gekennzeichnet, daß** die laterale Querschnittsfläche der vergrabenen Schicht (11) größer ist als die laterale Querschnittsfläche des Teilbereichs (10').

10. Integrierte Halbleiterschaltung nach einem der Ansprüche 1 bis 9,
**dadurch gekennzeichnet, daß** die Emitterzone (14) eine höhere Dotierungskonzentration aufweist als die Basiszone (13).

11. Integrierte Halbleiterschaltung nach einem der Ansprüche 6 bis 10,
**dadurch gekennzeichnet, daß** die Dotierungskonzentration in der Anschlußzone (16) mindestens 1*10¹⁹ cm⁻³ beträgt.

12. Integrierte Halbleiterschaltung nach einem der Ansprüche 1 bis 11,
**dadurch gekennzeichnet, daß** die Dotierungskonzentration in der vergrabenen Schicht (11) mindestens 1*10¹⁹ cm⁻³ beträgt.

13. Integrierte Halbleiterschaltung nach einem der Ansprüche 1 bis 12,
**dadurch gekennzeichnet, daß** zwischen der vergrabenen Schicht (11) und dem Anschlußpad (5) eine Anodenzone vorgesehen ist.

14. Halbleiterspeicher oder Logikbauteil oder Mikrokontroller mit einer integrierten Schaltung nach einem der vorhergehenden Ansprüche.

## Claims

1. Integrated semiconductor circuit (1), which is arranged in a semiconductor body (7),
a) having at least one terminal pad (5), which is connected via an electrically conductive connecting line (4) to the integrated semiconductor circuit (1),
b) having at least one first busbar (2), which carries a first supply potential (VCC) of the integrated semiconductor circuit (1) during operation,
c) having at least one second busbar (3), which carries a second supply potential (VSS) of the integrated semiconductor circuit (1) during operation,
d) having at least one protective element (6) for protecting the integrated semiconductor circuit (1) against electrostatic discharge, the protective element (6) being arranged between the terminal pad (5) and the integrated semiconductor circuit (1) and being connected to at least one of the busbars (2, 3),
e) the protective element (6) having at least one integrated vertical protective transistor (T), whose load path is connected between the connecting line (4) and one of the busbars (2, 3) and whose base can be driven via via [sic] integrated driving means,
f) the protective element (6) having current-carrying means, the current-carrying means dividing a parasitic current pulse into a horizontal component and a vertical component,
g) the collector of the protective transistor (T) being formed in the semiconductor body (7) by means of at least one buried layer (11) of the first conduction type,
h) at least one base zone (13) of the second conduction type, which base zone is introduced into a partial region (10') of an epitaxial layer (10) of the first conduction type and is spaced apart from the buried layer (11), acts as the base,
i) at least one emitter zone (14) of the first conduction type which emitter zone is introduced into the base zone (13) acting as the emitter,
j) at least one base contact zone (17) of the first conduction type being provided, which base contact zone is introduced into the base zone (13) and has a higher doping concentration than the base zone (13),
**characterized in that**
at least one base drift zone (15) of the first conduction type is provided, which base drift zone is arranged between the base zone (13) and the buried layer (11), and
the current-carrying means comprise the horizontal displacement of the base drift zone (15) relative to the base contact zone (17).

2. Integrated semiconductor circuit [lacuna] Claim 1, **characterized in that** the driving means contain at least one reverse-biased integrated diode (D) arranged in between buried layer (11) and base drive zone (15).

3. Integrated semiconductor circuit according to one of the preceding claims,
**characterized in that** the driving means contain at least one integrated resistor (R).

4. Integrated semiconductor circuit according to Claim 3,
**characterized in that** the conductance of the integrated resistor (R) is defined by the doping concentration in the base zone (13).

5. Integrated semiconductor circuit according to one of Claims 1 to 4,
**characterized in that** the activation voltage of the protective element (6) is defined by the doping concentration of the base drift zone (15) and by the thickness of the base drift zone (15).

6. Integrated semiconductor circuit according to one of Claims 1 to 5,
**characterized in that** at least one connection zone (16) is provided which is connected to the buried layer (11) and to one of the busbars (2, 3).

7. Integrated semiconductor circuit according to Claim 6,
**characterized in that** the connection zone (16) is arranged annularly around the base zone (13) or the base drift zone (15).

8. Integrated semiconductor circuit according to either of Claims 6 and 7,
**characterized in that** the connection zone (16) is spaced equidistantly from the base zone (13) and/or the base drift zone (15) by a distance (d).

9. Integrated semiconductor circuit according to one of Claims 6 to 8,
**characterized in that** the lateral cross-sectional area of the buried layer (11) is larger than the cross-sectional area of-the partial region (10').

10. Integrated semiconductor circuit according to one of Claims 1 to 9,
**characterized in that** the emitter zone (14) has a higher doping concentration than the base zone (13).

11. Integrated semiconductor circuit according to one of Claims 6 to 10,
**characterized in that** the doping concentration in the connection zone (16) is at least 1^{*}10¹⁹ cm⁻³.

12. Integrated semiconductor circuit according to one of Claims 1 to 11,
**characterized in that** the doping concentration in the buried layer (11) is at least 1*10¹⁹ cm⁻³.

13. Integrated semiconductor circuit according to one of Claims 1 to 12,
**characterized in that** an anode zone is provided between the buried layer (11) and the terminal pad (5).

14. Semiconductor memory or logic component or microcontroller having an integrated circuit according to one of the preceding claims.

## Revendications

1. Circuit à semi-conducteur intégré (1) disposé dans un corps semi-conducteur (7),
a) comprenant au moins une plage de contact (5) qui est reliée au circuit à semi-conducteur intégré (1) par l'intermédiaire d'une ligne de raccordement (4) conductrice,
b) comprenant au moins un premier rail de potentiel (2) qui, en fonctionnement, véhicule un premier potentiel d'alimentation (VCC) du circuit à semi-conducteur intégré (1),
c) comprenant au moins un deuxième rail de potentiel (3) qui, en fonctionnement, véhicule un deuxième potentiel d'alimentation (VSS) du circuit à semi-conducteur intégré (1),
d) comprenant au moins un élément de protection (6) pour protéger le circuit à semi-conducteur intégré (1) d'une décharge électrostatique, l'élément de protection (6) étant disposé entre la plage de contact (5) et le circuit à semi-conducteur intégré (1) et relié à au moins l'un des rails de potentiel (2, 3),
e) l'élément de protection (6) présentant au moins un transistor de protection (T) vertical intégré, dont la voie de charge est branchée entre la ligne de raccordement (4) et l'un des rails de potentiel (2, 3), et dont la base peut être excitée à l'aide de moyens d'excitation intégrés,
f) l'élément de protection (6) présentant des moyens conducteurs de courant, les moyens conducteurs de courant divisant une impulsion de courant parasite en une partie horizontale et une partie verticale,
g) le collecteur du transistor de protection (T) dans le corps semi-conducteur (7) étant constitué par au moins une couche enfouie (11) du premier type de conduction,
h) au moins une zone de base (13) du deuxième type de conduction insérée dans une zone partielle (10') d'une couche épitaxiale (10) du premier type de conduction, à distance de la couche enfouie (11), agissant comme base,
i) au moins une zone d'émetteur (14) du premier type de conduction, insérée dans la zone de base (13), agissant comme émetteur,
j) au moins une zone de contact de base (17) du premier type de conduction, insérée dans la zone de base (13), étant prévue, qui présente une concentration de dopage plus importante que la zone de base (13),
**caractérisé en ce qu'**au moins une zone de dérive de base (15) du premier type de conduction est prévue, qui est disposée entre la zone de base (13) et la couche enfouie (11), et **en ce que** les moyens conducteurs de courant sont constitués par le décalage horizontal de la zone de dérive de base (15) par rapport à la zone de contact de base (17).

2. Circuit à semi-conducteur intégré selon la revendication 1, **caractérisé en ce que** les moyens d'excitation comprennent au moins une diode intégrée (D) disposée entre la couche enfouie (11) et la zone de dérive de base (15), et commutée dans le sens du blocage.

3. Circuit à semi-conducteur intégré selon l'une des revendications précédentes, **caractérisé en ce que** les moyens d'excitation comprennent au moins une résistance intégrée (R).

4. Circuit à semi-conducteur intégré selon la revendication 3, **caractérisé en ce que** la conductance de la résistance intégrée (R) est déterminée par la concentration de dopage dans la zone de base (13).

5. Circuit à semi-conducteur intégré selon l'une des revendications 1 à 4, **caractérisé en ce que** la tension de commutation de l'élément de protection (6) est déterminée par la concentration de dopage de la zone de dérive de base (15) et par l'épaisseur de la zone de dérive de base (15).

6. Circuit à semi-conducteur intégré selon l'une des revendications 1 à 5, **caractérisé en ce qu'**au moins une zone de contact (16) est prévue, qui est reliée à la couche enfouie (11) et à l'un des rails de potentiel (2, 3).

7. Circuit à semi-conducteur intégré selon la revendication 6, **caractérisé en ce que** la zone de contact (16) est disposée en forme d'anneau autour de la zone de base (13) ou de la zone de dérive de base (15).

8. Circuit à semi-conducteur intégré selon l'une des revendications 6 ou 7, **caractérisé en ce que** la zone de contact (16) est équidistante d'une distance (d) par rapport à la zone de base (13) et/ou à la zone de dérive de base (15).

9. Circuit à semi-conducteur intégré selon l'une des revendications 6 à 8, **caractérisé en ce que** la surface en coupe transversale latérale de la couche enfouie (11) est supérieure à la surface de section transversale latérale de la zone partielle (10').

10. Circuit à semi-conducteur intégré selon l'une des revendications 1 à 9, **caractérisé en ce que** la zone d'émetteur (14) présente une concentration de dopage plus importante que la zone de base (13).

11. Circuit à semi-conducteur intégré selon l'une des revendications 6 à 10, **caractérisé en ce que** la concentration de dopage dans la zone de contact (16) est d'au moins 1*10¹⁹ cm⁻³.

12. Circuit à semi-conducteur intégré selon l'une des revendications 1 à 11, **caractérisé en ce que** la concentration de dopage dans la couche enfouie (11) est d'au moins 1*10¹⁹ cm⁻³.

13. Circuit à semi-conducteur intégré selon l'une des revendications 1 à 12, **caractérisé en ce qu'**une zone d'anode est prévue entre la couche enfouie (11) et la plage de contact (5).

14. Mémoire à semi-conducteur ou composant logique ou microcontrôleur comprenant un circuit intégré selon l'une des revendications précédentes.
